# EUROPEAN PATENT APPLICATION

(11) **EP 2 169 824 A1**
(43) Date of publication of application: **31.03.2010**
(21) Application number: 08165068.1
(22) Date of filing: 25.09.2008
(51) Int. Cl.: H03F 3/00, G05F 3/26, H03H 19/00, H03F 3/45

(54) **A switched capacitor error amplifier circuit for generating a precision current reference or for use in a precision oscillator**

(71) Applicant: Moscad Design & Automation Sàrl, 1261 Le Vaud (CH)
(72) Inventor: Ballenegger, Florian, 1269 Bassins (CH)
(74) Representative: Leman Consulting S.A.

(57) **Abstract**

The invention allows for the realization of a precision current reference or a fully integrated crystal-less precision oscillator by providing a circuit that precisely controls the cyclic charging operation of a switched capacitor. The voltage across the switched capacitor is ramped up and stops at the end of the charge phase at precisely a desired voltage. By using an appropriate network of switches based around a transconductance amplifier, the error voltage between the desired voltage and the voltage across the switched capacitor is amplified by the transconductance amplifier to give an error current. The error current is integrated over time to give an error signal. By using appropriate feedback, the current can be stabilised to give a precise output current whose value depends on a capacitance, a voltage and a frequency, or it can be used as part of a frequency locked loop to provide a precise crystal-less oscillator whose frequency depends on a resistance and a capacitance. The circuit is insensitive to amplifier offset and bandwidth. The circuit also comprises means to compensate for temperature variations and means to compensate for variations in resistance and capacitance commonly occurring in integrated circuits due to process variations.

## Description

### INTRODUCTION

The present invention relates to the domain of current reference generators and more particularly to the use of switched capacitor techniques for controlling the operation of such circuits. The invention can also be applied to the domain of precision oscillators.

### BACKGROUND OF THE INVENTION

Switched capacitor networks are widely used in the design of electronics circuits in view of their ability to simulate a resistive load in a circuit. Using a switched capacitor Csw, switched at a frequency fsw, an equivalent resistance of Req can be realised where Req=1/(fsw*Csw). It is well known that in the fabrication of semiconductor integrated circuits, absolute precision of resistance values is not easily achievable whereas absolute precision of capacitance values is well within the control of the most semiconductor fabrication processes. For this reason, the use of switched capacitor circuits in analogue semiconductor circuit design, in situations where precise resistance values are required, is of particularly importance.

A current reference circuit is an important building block in analogue and mixed signal circuit design, where it used to bias various circuit modules such as op-amps, comparators, data converters etc. Such current reference circuits can be realised using a switched capacitor, a comparator, a voltage reference and a reference clock as is described in US Patent Application Publication 2006/0119422A1, Semiconductor Device Including Current Control Circuit of Reference Current Source, Sakurai et al., Jun. 8, 2006.

Another important building block in analogue and mixed signal circuit design is an oscillator. Normally, in order to build an accurate oscillator, a crystal or a ceramic resonator would be used. This leads to bulky and expensive solutions which are not very flexible due to the fact that they usually have preset frequencies corresponding to the frequency of available crystals or ceramics.

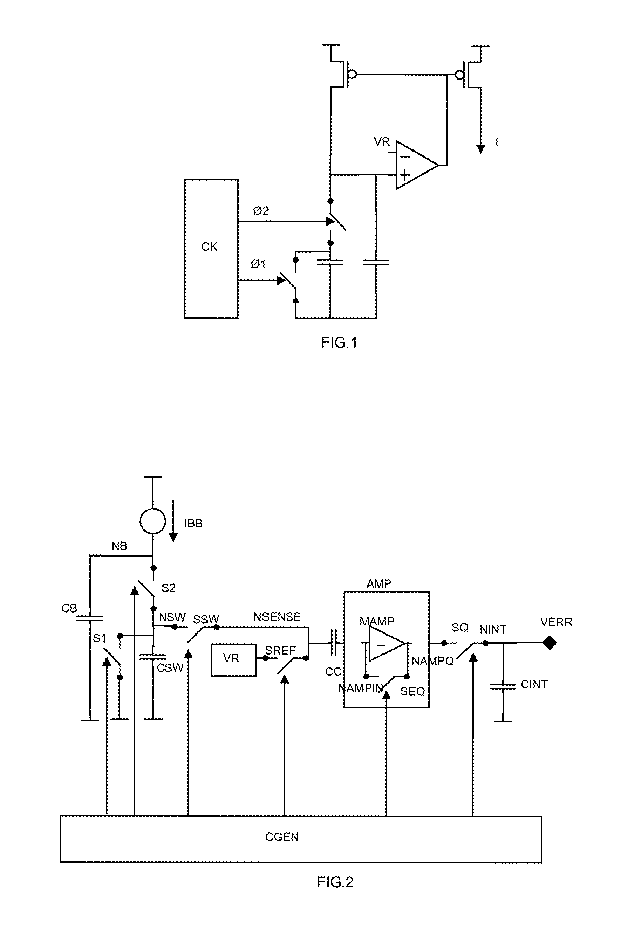

Using a switched capacitor network with a controllable oscillator and a divider in a closed loop configuration a very accurate and flexible oscillator can be realised. An example of such a circuit is described by T.R. Viswanathan, S. Murtuza, V.H. Syed and M. Staszel, in "Switched-Capacitor Frequency Control Loop", IEEE Journal of Solid State circuits, Vol. 17, Issue No. 4, August 1982, pp. 774-778. FIG.1 illustrates the manner in which a switched capacitor and an amplifier are generally used in circuits inspired by the work of Viswanathan et al. to obtain a desired voltage across the switched capacitor. In this circuit, a switched capacitor is used in a feedback circuit with an operational amplifier configured to respond to the difference between a reference voltage and the voltage across the switched capacitor. The difference thus detected is used to control the amount of current in the switched capacitor.

The above design suffers from some drawbacks, which will now be described. In a first phase, the switched capacitor is decoupled from the operational amplifier and discharged. In a second phase, the switched capacitor is re-connected to the operational amplifier. Since the input of the operational amplifier has a buffer capacitor connected in parallel with the switched capacitor, at the moment the switched capacitor is reconnected to the operational amplifier, the voltage at the input of the operational amplifier drops due to the parallel combination of the switched capacitor and the buffer capacitor. The current source at the input of the operational amplifier charges the capacitor pair up until the end of the second phase. The result is that the operational amplifier input is subject to a sawtooth waveform, thus leading to precision errors.

The present invention aims to remedy this problem by first charging the switched capacitor to a value close to the reference voltage, holding said voltage and then connecting the switched capacitor to the amplifier. The amplifier design is also modified in order to minimise errors due to the amplifier itself. Using this building block in different embodiments of the present invention, it is shown how to design either a precision constant current reference circuit based on a capacitance, a voltage value and a switching frequency or a precision frequency generator or a precision oscillator based on a resistance and a capacitance. The present invention is thus insensitive to such effects as amplifier offset and bandwidth limitations due to the limited bandwidth and non-linear settling behaviour of the op-amp.

### SUMMARY OF THE INVENTION

The present invention allows for the realisation of a precision current generator or a precision oscillator by using, as a building block, a switching circuit device to provide an output current, said switching circuit device comprising:
- at least one reference voltage source to provide a reference voltage,
- a plurality of switch elements, said switch elements having a control input and two terminals, said control input allowing for the two terminals to be either connected together or open-circuited,
- a clock generator to control the plurality of switch elements,
- a buffer capacitor, polarised at a buffer node by a buffer bias current,
- a switched capacitor,
- a first subset of the plurality of switch elements configured to allow the switched capacitor to be either connected to the buffer node or open circuited or discharged,
   characterised in that said switching circuit device further comprises:
- an amplifier comprising at least an amplifying element, the input of said amplifier being capacitively coupled to a sense node,
- a second subset of the plurality of switch elements configured to allow said amplifier either to function as an integrating amplifier, whereby the output of said amplifier is connected to an integrating capacitor thus providing the error signal, or to be auto-zeroed, whereby the input of the amplifying element is connected to the output of the amplifying element while the output of the amplifier is disconnected from the integrating capacitor,
- a third subset of the plurality of switch elements configured to allow either the switched capacitor or the reference voltage to be alternately connected to the sense node.

A method for using the above switching circuit device is also described, characterised in that said method comprises the following steps:
- in a first phase, connecting the switched capacitor to the buffer capacitor, thus allowing both of said capacitors to be charged in parallel,
- in a second phase, disconnecting the switched capacitor from the buffer capacitor and connecting the switched capacitor to the sense node,
- in a third phase, disconnecting the switched capacitor from the sense node and discharging the switched capacitor,
   and further characterised in that one of the following combinations of steps takes place:
- either the reference voltage is connected to the sense node and the amplifier is activated during the third phase,
- or the reference voltage is connected to the sense node during the third phase and the amplifier is activated during the first and second phases,
- or the reference voltage is connected to the sense node during the first phase and the amplifier is activated during the second and third phases,
- or the reference voltage is connected to the sense node during the first phase and the amplifier is activated during the first phase,
   wherein each of the three phases are cycled on a continuous basis thus allowing an output current to be obtained at the output of said switching circuit device.

### BRIEF DESCRIPTION OF THE DRAWINGS

The following detailed description of a preferred embodiment of the present invention will best be understood when read in conjunction with the accompanying drawings, wherein:
FIG.1 is a schematic diagram of a conventional switched capacitor current generator circuit.
FIG.2 is a schematic diagram of the solution proposed in the present invention.
FIG.3 shows a table summarising the various different timing possibilities related to the control of the circuit of the present invention.
FIG.4 shows a timing diagram summarising the various possible timing scenarios related to the control of the circuit of the present invention.
FIG.5 is a timing diagram relative to the schematic diagram of FIG.2.
FIG.6 is a schematic diagram of an embodiment of the present invention in a closed loop circuit, wherein said closed loop circuit is designed to provide a substantially constant and precise output current, thus overcoming certain deficiencies in the conventional circuit of FIG.1.
FIG.7 shows a schematic of the folding cascode stage used in the amplifier of FIG.6.
FIG.8 is a schematic diagram of an embodiment of the present invention in a closed loop circuit, wherein said closed loop circuit is designed to provide a substantially constant and precise output clock.
FIG.9 shows a method using programmable switches to modify the current in one branch of a group of transistor branches arranged in a current mirror topology, used to compensate for variations in operating characteristics of the switching circuit device due to variations caused by the manufacturing process.
FIG.10 shows a schematic of a solution used in the switching circuit device for compensating for variations in operating characteristics due to variations in temperature.

### DETAILED DESCRIPTION OF A PREFERRED EMBODIMENT

The present invention describes a switching circuit using a switched capacitor, a voltage reference and a single-input amplifier associated with a plurality of switches allowing it to be configured as an error-integrating amplifier, to provide an error signal. The switches in the circuit are controlled by a clock generator. The circuit is to be used preferably in a feedback loop in order to provide either a stable and precise current output to be used as a current reference generator for example, or to provide a precise output frequency to be used as a crystal-less precision oscillator. In the first case, the clock generator is driven by a precise crystal oscillator and the reference voltage is provided by a precise voltage generator such as a bandgap reference generator. In the second case, the circuit generates an output clock, which is fed back to control the clock generator. The present invention further allows for such a reference current generator or such an oscillator to be calibrated with respect to variations in device characteristics due to process variations during the fabrication of the circuit. Provision is yet further made to allow for temperature compensation to be achieved in the case that any resistors or capacitors used in the circuit would have a significant variation with temperature. By nature of the use of a single-input amplifier and the switching method used, the present invention is insensitive to such effects as bandwidth limitations and amplifier offset, while the effect of flicker noise in the amplifier is attenuated.

The invention is shown in FIG.2. A switched capacitor (CSW) is charged, by a buffer bias current (IBB), to as close as possible to a desired voltage, the desired voltage being equal to the reference voltage (VR). By appropriately controlling a set of switches to connect in turn the switched capacitor voltage (NSW) then the reference voltage (VR) to a sense node (NSENSE), the difference between the voltage on the switched capacitor and the desired voltage can be amplified (AMP) to give an error current. The error current can be integrated over time onto an integrating capacitor (CINT) to give an integrated error voltage (VERR). The integrated error voltage may be used as part of a feedback loop either to control the buffer bias current which charges the switched capacitor or to control a current controlled oscillator, whose output can be used to control the switching of the switched capacitor and the associated switches of the switching circuit.

The amplifier comprises at least one amplifying element. In the particular example of FIG.2 the amplifying element could be an N-type MOSFET (NMOS) biased by a P-type MOSFET (PMOS). The input of the amplifying element is capacitively coupled to the sense node (NSENSE). The amplifier has a feedback switch (SEQ) and an output switch (SQ). A buffer capacitor (CB) is charged by the buffer bias current (IBB). The switched capacitor (CSW) is connected between a switched node (NSW) and a common DC reference plane, which in this case is ground, and the switched node can either be connected to the buffer capacitor (CB) at a buffer node (NB) and thus charged in parallel with the buffer capacitor, or it can be discharged to the common DC reference plane, or it can be isolated thus allowing the switched capacitor to hold the charge on the switched node. A set of switches (SSW, SREF) is arranged whereby the sense node (NSENSE) is connected either to the reference voltage (VR) or the switched node (NSW).

Variations of this circuit can be realised wherein the common DC reference plane is a positive power supply rather than ground. Similarly, the polarity of the buffer bias current could be inversed, the amplifying element could be a PMOS biased by an NMOS or the output driver could comprise a current source opposite in polarity to that described in FIG.2.

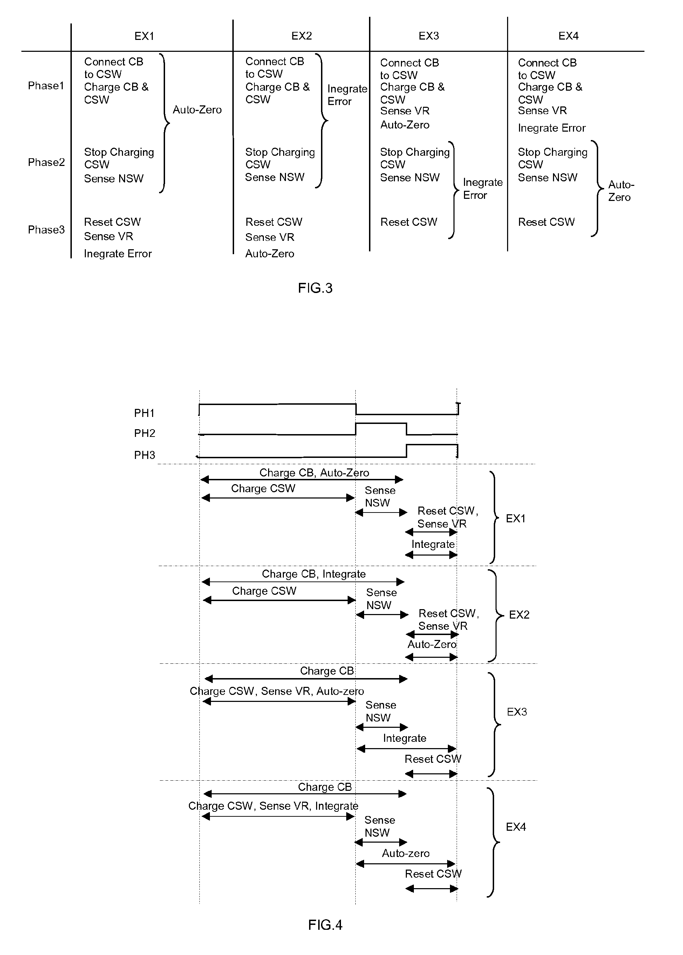

The switching circuit preferably works in three phases. Depending on the particular options used in the architecture of the circuit, e.g. NMOS or PMOS amplifying element, common DC reference plane being ground or a positive power supply, current biases either sourcing or sinking current, then different timing scenarios are possible, however the main objective remains the same. In a first phase, both the switched node and the reference voltage are disconnected from the sense node, while the buffer capacitor is connected in parallel with the switched capacitor at the buffer node, allowing the buffer bias current to act upon the switched capacitor in parallel with the buffer capacitor. In a second phase, when ideally, the switched node has reached the same potential as the reference voltage, the switched capacitor is disconnected from the buffer bias current, therefore allowing the buffer bias current to continue to act on the buffer capacitor alone, while the switched node is connected to the sense node. A third phase then ensues, during which the switched capacitor is reset by connecting it to whichever common DC reference plane is being used according to the particular circuit architecture. Again depending on the chosen architecture, the reference node can be connected to the sense node (i.e. sensed) either during the third phase or during the first phase. Two other operations need to be carried out to complete the procedure, namely the auto-zeroing of the amplifier and the integrating of the error current. These two operations are mutually exclusive (i.e. integrating error when not auto-zeroing and auto-zeroing when not integrating error). Auto-zeroing consists in connecting the input of the amplifying element to its input while disconnecting the output of the amplifier from the integrating capacitor. Integrating the error current consists in connecting the output of the amplifier to the integrating capacitor while disconnecting the output of the amplifier from its input. During at least part of the time that the auto-zeroing is being carried out, either the switched node or the reference voltage will be connected to the sense node thereby defining an initial state. During at least part of the time that error integrating is being done, the other node (i.e. the reference voltage or the switched node) will be connected to the sense node, thereby shifting the input of the amplifier from its initial state. Auto-zeroing may therefore occur during both the first and second phases when the switched node is sensed during the second phase and the reference node is sensed during the third phase. Similarly, auto-zeroing may occur during just the first phase when the reference node is sensed during the first phase and the switched node is sensed during the second phase. Another possibility is for the auto-zeroing to occur during the third phase when the switched node is sensed during the second phase and the reference node is sensed during the third phase. Lastly, the auto-zeroing could occur during both the second and third phases when the switched node is sensed during the second phase and the reference node is sensed during the first phase. FIG.3 shows a table summarizing the different possibilities mentioned above. FIG.4 shows the same information graphically in a timing diagram.

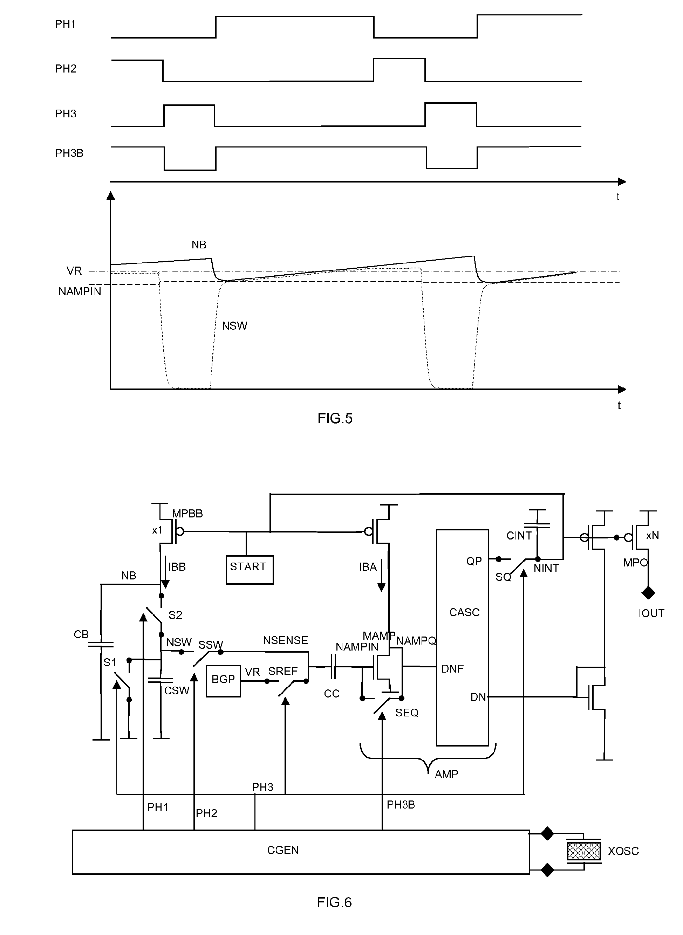

FIG.5 shows a timing example for the circuit in FIG.2 in the case where the amplifying element is an NMOS and the common reference DC plane is ground. The figure shows the buffer capacitor (CB) and the switched capacitor (CSW) being charged together during the first phase. The purpose of the buffer capacitor is to limit the voltage swing at the buffer node (NB). Charging of the switched capacitor (CSW) is stopped (S2) at the second phase, leaving the buffer capacitor (CB) to continue to be charged alone, at which point the voltage on the switched node (NSW) is close to the reference voltage (VR). In this example the amplifier (AMP) is auto-zeroed during the first and second phases. During this time, the voltage at the input (NAMPIN) of the auto-zeroed amplifier is determined solely by the amplifier's bias current. The establishment of the quiescent state of the amplifier thus achieved will be independent of the state of the sense node (NSENSE) since the input of the amplifier is only capacitively coupled (CC) to the sense node. In the second phase, with the amplifier still being held in auto-zero state, the switched node is connected (SSW) to the sense node. At the third phase, the switched capacitor is reset by discharging it to ground (S1) and the switched node is disconnected from the sense node (SSW). Furthermore, auto-zeroing of the amplifier is discontinued (SEQ), the reference voltage is connected (SREF) to the sense node and the input of the amplifier shifts by a voltage proportional to the difference between the reference voltage and the voltage at which the charging of the switched node was stopped (VNSW-VR=Verr). The difference (Verr) is amplified, and the error current, gm*Verr, where gm is the transconductance of the amplifier, is integrated onto the integrating capacitor (CINT). If there is no difference between the reference voltage and the voltage at which the charging of the switched node was stopped, then the voltage on the integrating capacitor remains constant.

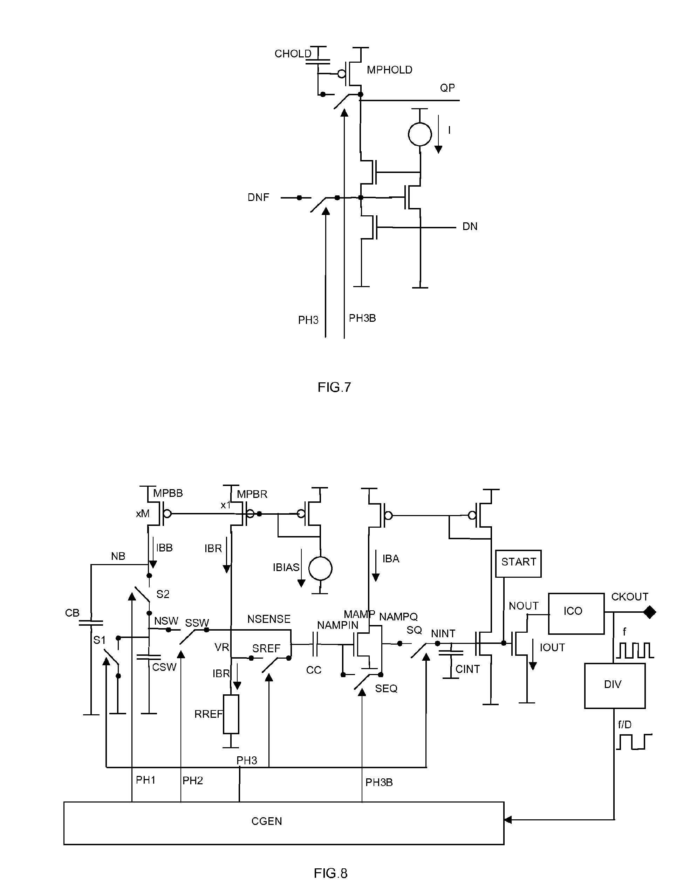

FIG.6 shows an embodiment of the present invention configured to implement a precision current reference generator. In this embodiment, a precise crystal oscillator (XOSC) operating at a frequency fSW is used to drive the clock generator (CGEN) and a precise voltage reference such as a bandgap voltage reference generator is used to provide the reference voltage (VR). An output driver is used in this embodiment to provide the output current, said output driver comprising a PMOS, therefore the integrating capacitor is coupled to the positive supply to achieve better power supply rejection. The amplifier in this case further comprises a folding cascode arrangement of NMOS transistors (CASC) so that changes in voltage at the output of the amplifying element are isolated from the integrating node (NINT), thus rendering the current output of the switching circuit less prone to power supply ripple. The folding cascode arrangement thus provides a convenient way to allow changes in current produced by the NMOS amplifying element to be reflected onto the PMOS side and the integrating capacitor while allowing the voltages on the gates of the PMOS's to be reached independently of the voltage at the output of the amplifier. The folding cascode stage is illustrated in FIG.7. During the first and second phases, while the amplifier is in auto-zero mode, a holding capacitor (CHOLD) stores the voltage corresponding to the quiescent state of the folding cascode stage. During the third phase, when the amplifying element gives a change in current due to the voltage difference between the reference voltage and the voltage on the switched capacitor, the gate of MPHOLD is maintained by the holding capacitor (CHOLD) and the drain is connected to the integrating capacitor (CINT). The change in current provided by the amplifying element is reflected and integrated onto CINT. Since the integrating node (NINT) is isolated from the amplifier output thanks to the folding cascode arrangement, the voltage change at NINT is independent of the voltage change at the amplifier output. The output current is generated by applying the voltage at the integrating node to the gate of a PMOS (MPO). The current thus achieved can be mirrored via PMOS devices, to be used both to bias the amplifying element and to provide the bias current for the buffer capacitor, thus closing the feedback loop to provide a precise and stable current reference determined by CSW*VR*fSW*N, where N is the ration of the width of the output PMOS (MPO) to the width of the PMOS current source on the switched capacitor (MPBB), given that they have the same length.

In order to guarantee the precision of the current reference generator thus described, there has to be extremely good matching between the sizes and characteristics of the PMOS devices MPO and MPBB. One of the consequences of this is that these two transistors need to be very large. The fact that these transistors are large means that most of the capacitance value of the integrating capacitor (CINT) is made up of the parasitic capacitance of the gates of MPO and MPBB.

As well as the desired mode of operation described above, the switching circuit in FIG.4 also has a stable mode of operation wherein the current at the output (IOUT) is zero and the bias current in the amplifier (IBA) as well as the bias current for the buffer capacitor (IBB) are zero. To avoid the circuit entering this useless mode, a startup circuit is included whereby when the circuit is initially powered up, the voltage on node NINT is temporarily pulled down in order to make sure that current starts to flow and that the circuit starts up and reaches the desired mode of operation.

FIG.8 shows another embodiment of the present invention wherein the error signal is converted to a current by a driver circuit to drive a controlled oscillator thus giving an output clock (CKOUT). The frequency of the output clock may be divided down and the signal thus produced used to drive the clock generator (CGEN) to provide the signals to control the switching of the switched capacitor (CSW) and the other switches defining the three phases described above. The output current from the driver circuit (IOUT) is also mirrored back to be used to bias the amplifying element (MAMP), thus making sure that the input of the amplifier (NAMPIN) is always at its optimum voltage. In this embodiment, the reference voltage (VR), which need not be precise, is generated by forcing a reference bias current (IBR) through a reference resistor (RREF). The reference bias current (IBR) can be generated by mirroring a bias current source (IBIAS). The same bias current source (IBIAS) can be mirrored to be used as a buffer bias current (IBB). The embodiment thus described forms a very effective frequency locked loop and can be used as a precision crystal-less oscillator whose output frequency at CKOUT is determined by D*M/(RREF*CSW), where D is the ratio by which the divider reduces the frequency of the output clock and M is the ration of the width of the PMOS current source (MPBB) on the switched capacitor (CSW) to the width of the PMOS current source (MPBR) on the reference resistor (RREF), given that they have the same length.

As well as the desired mode of operation described above, the switching circuit in FIG.8 also has a stable mode of operation wherein the current at IOUT is zero and therefore there is no clock signal at CKOUT. To avoid the circuit entering this useless mode, a startup circuit is included whereby when the circuit is initially powered up, a small current is temporarily injected into the node NINT in order to start the controlled oscillator and to start up the amplifier and so make sure that current starts to flow and that the circuit starts up and reaches the desired mode of operation.

It is well known that in the fabrication of semiconductor integrated circuits, absolute precision of resistance values is not easily achievable. Therefore, in the case that the circuit described above is fabricated on a semiconductor integrated circuit, provision is made to compensate for the effects of variations in the value of the on-chip resistances on the circuit's performance. This provision is made either by intervening on the value of the reference resistor (RREF) or by intervening on the reference bias current (IBR) or by intervening on the value of the switched capacitor (CSW) or by a combination of any of these interventions.

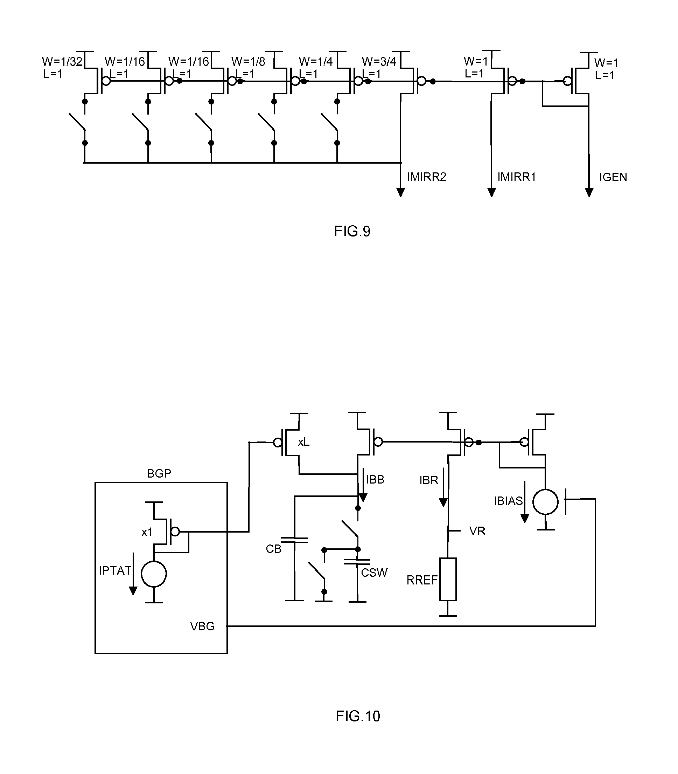

To allow for an intervention on the value of reference resistor (RREF), said resistor is built from a number of sections of resistances which can be combined in an adequate manner, using programmable switches, to give a desired final resistance for each individual circuit. To intervene on the reference bias current, the ratio of the current in the reference resistor to the buffer bias current (IBB), which is used to charge the switched capacitor (CSW), can be modified by building at least one of the transistors involved in the current mirror configuration relating these currents, from a number of parallel sections of transistor, each of which can be included or excluded from the mirror using programmable switches. It could be arranged for the parallel sections of transistor to be of varying widths so that the granularity of the addition/exclusion of sections of transistor could be optimised (FIG.9). To allow for an intervention on the value of the switched capacitor (CSW), said capacitor is built in a number of sections which can be combined in an adequate manner using programmable switches to give the total final capacitance.

Any of the circuits described above may be sensitive to temperature changes. This is the case for example in the embodiment described in FIG.8 since the reference resistance (RREF) will vary with temperature. In fact the value of the reference voltage is inversely proportional to absolute temperature and can be described as IBIAS*RREFO(1+TCR*T), where TCR is the temperature coefficient of RREF (and is negative), T is the absolute temperature and RREF0 is the value of RREF at 0K. This means that the reference voltage will decrease as the temperature rises. Compensation must be made therefore by increasing the buffer bias current as the temperature increases. On the other hand, a bandgap voltage reference circuit generally comprises a current generator, the current from which (IPTAT) is defined by design and is proportional to absolute temperature. It is sufficient therefore to reflect part of the current from the bandgap generator and add it to the buffer bias mirror using a temperature compensation current mirror. The amount of current to be mirrored is given by the relationship X*IPTAT/T=IBIAS*TCR where X is the ratio of sizes of transistors used in the temperature compensating current mirror. An example of a circuit with temperature compensation is shown in FIG.10. In practice it turns out that the compensation current is generally a small fraction of the current in the bandgap generator, therefore X<<1.

This same technique described above can be used to compensate for variations in the value of the capacitance (CSW) with temperature. The total amount of current mirrored from the bandgap generator to be added to the buffer bias current is then given by X*IPTAT/T=IBIAS*(TCR+TCC) where TCC is the temperature coefficient of the switched capacitor (CSW).

Thus, it is seen that the present invention as described herein provides for a switched capacitor bias circuit for generating a precision current reference or for use in a precision oscillator. The preferred embodiments taught by the present invention are presented for the purpose of illustration rather than of limitation. Those skilled in the art will appreciate that the present invention can be practiced by embodiments other than those described herein without departing from the spirit of the present invention, which is limited only by the claims which follow.

## Claims

1. A switching circuit device to provide an error signal, said switching circuit device comprising:
- at least one reference voltage source to provide a reference voltage,
- a plurality of switch elements, said switch elements having a control input and two terminals, said control input allowing for the two terminals to be either connected together or open-circuited,
- a clock generator to control the plurality of switch elements,
- a buffer capacitor, polarised at a buffer node by a buffer bias current,
- a switched capacitor,
- a first subset of the plurality of switch elements configured to allow the switched capacitor to be either connected to the buffer node or open circuited or discharged,
**characterised in that** said switching circuit device further comprises:
- an amplifier comprising at least an amplifying element, the input of said amplifier being capacitively coupled to a sense node,
- a second subset of the plurality of switch elements configured to allow said amplifier either to function as an integrating amplifier, whereby the output of said amplifier is connected to an integrating capacitor thus providing the error signal, or to be auto-zeroed, whereby the input of the amplifying element is connected to the output of the amplifying element while the output of the amplifier is disconnected from the integrating capacitor,
- a third subset of the plurality of switch elements configured to allow either the switched capacitor or the reference voltage to be alternately connected to the sense node.

2. The switching circuit device according to claim 1, **characterised in that** the amplifier has a single-ended input.

3. The switching circuit device according to either of claims 1 or 2, **characterised in that** the amplifying element is a transconductance amplifier wherein a voltage at the input of said transconductance amplifier is converted to a current at the output of said transconductance amplifier.

4. The switching circuit device according to any of claims 1 to 3, **characterised in that** the switching circuit further comprises an output driver to convert the error signal to an output current and further
**characterised in that**:
- the reference voltage is generated by a bandgap reference circuit to provide a substantially constant and precise voltage,
- the controllable clock generator circuit is driven by a crystal oscillator of constant frequency to provide substantially precise control signals for the switch elements,
- the buffer bias current is derived from a mirror of the output current of the switching circuit device wherein the value of said buffer bias current is a factor of the value of said output current,
wherein the output current thus generated by said switching circuit, once in equilibrium, is substantially constant and precise and has a value which is proportional to the product of the capacitance of the switched capacitor, the reference voltage and the frequency of the crystal oscillator.

5. The switching circuit device according to claim 4 **characterised in that** the amplifier further comprises a folding cascode stage to reduce the sensitivity of the output current to power supply ripple.

6. The switching circuit device according to any of claims 1 to 3, **characterised in that** the reference voltage is developed across a reference resistance by passing a reference bias current through said reference resistance, the value of said reference bias current being related to the buffer bias current by a current mirror configuration wherein the value of said reference bias current is a factor of the value of the buffer bias current, and wherein said switching circuit device further comprises:
- a controlled oscillator whose input is driven by the output of the switching circuit device and whose output provides a clock output signal,
- a frequency divider to divide the frequency of the clock output signal by at least one, the output of said frequency divider being used to control the clock generator,
wherein said switching circuit device thus configured, once in equilibrium, provides a substantially constant and precise clock output signal at the output of the controlled oscillator, whose frequency is inversely proportional to the product of the value of the reference resistance and the capacitance value of the switched capacitor.

7. The switching circuit device according to any of claims 4 to 6 **characterised in that** a startup circuit is used to ensure that a non-zero current flows in the controllable current source in the output driver stage, said startup circuit acting on said controllable current source until a current has started to flow.

8. The switching circuit device according to any of the claims 1 to 7, **characterised in that** said switching circuit device is in the form of a monolithic semiconductor integrated circuit.

9. The switching circuit device according to any of the claims 1 to 8, **characterised in that** the switch elements comprise at least one MOS device whose gate is the control input and whose source and drain are the terminals.

10. The switching circuit device according to any of claims 1 to 9, **characterised in that** at least one of the capacitors is at least partially made from a parasitic capacitance.

11. The switching circuit device according to any of claims 6 to 10 **characterised in that** said switching circuit device comprises a system for compensating for variations in resistivity of the reference resistance, said system comprising at least one of the following provisions:
- the reference resistance comprises a plurality of resistive sections each associated with at least one programmable switch to allow said resistive section to participate in or to be excluded from the overall resistance of said reference resistance,
- the switched capacitor comprises a plurality of capacitive sections each associated with at least one programmable switch to allow said capacitive section to participate in or to be excluded from the overall capacitance of said switched capacitor,
- at least one branch of the current mirror configuration comprises at least one transistor and a plurality of parallel sections of transistor, each of said sections of transistor being connected via a programmable switch to said branch to allow said section to be included in or to be excluded from said branch.

12. The switching circuit device according to any of claims 1 to 10 **characterised in that** said switching circuit device further comprises a system for compensating for variations in the value of the reference resistance and/or for variations in the value of the switched capacitor due to variations in temperature, said system comprising a temperature compensation current mirror to reflect a proportion of a current whose value is proportional to temperature, said proportion of current being added to the buffer bias current or to the reference bias current, said temperature compensating current mirror satisfying the condition that the amount of current reflected is equal to the product of the current whose value is proportional to temperature and the sum of the temperature coefficients of the materials for which temperature compensation is being sought.

13. A method for controlling a switching circuit device to provide an error signal, said switching circuit device comprising:
- a reference voltage,
- a switched capacitor,
- a plurality of switch elements,
- a buffer capacitor polarised by a buffer bias current,
- an amplifier having a single-ended input, said amplifier comprising an least an amplifying element, the input of said amplifier being capacitively coupled to a sense node,
- an integrating capacitor connected to the output of the amplifier via a switch element,
- means to auto-zero the amplifier whereby the input of the amplifying element is connected to the output of the amplifying element,
- means to activate the amplifier whereby the output of said amplifier is connected to the integrating capacitor, said means to activate the amplifier being employed at periods which are mutually exclusive to the periods when the means for auto-zeroing the amplifier are employed,
- a clock generator circuit to control the plurality of switch elements,
**characterised in that** said method comprises the following steps:
- in a first phase, connecting the switched capacitor to the buffer capacitor, thus allowing both of said capacitors to be charged in parallel,
- in a second phase, disconnecting the switched capacitor from the buffer capacitor and connecting the switched capacitor to the sense node,
- in a third phase, disconnecting the switched capacitor from the sense node and discharging the switched capacitor,
and further **characterised in that** one of the following combinations of steps takes place:
- either the reference voltage is connected to the sense node and the amplifier is activated during the third phase,
- or the reference voltage is connected to the sense node during the third phase and the amplifier is activated during the first and second phases,
- or the reference voltage is connected to the sense node during the first phase and the amplifier is activated during the second and third phases,
- or the reference voltage is connected to the sense node during the first phase and the amplifier is activated during the first phase,
wherein each of the three phases are cycled on a continuous basis thus allowing the error signal to be obtained at the integrating capacitor.

14. The method according to claim 13 applied to the switching circuit device further comprising:
- a bandgap reference voltage generator to provide the reference voltage and
- a crystal oscillator to drive the clock generator circuit,
**characterised in that** said method comprises the following steps:
- generating the buffer bias current by mirroring at least part of the output current, and
- obtaining a substantially constant and precise output current from the switching circuit device, said substantially constant and precise output current being proportional to the product of the capacitance of the switched capacitor, the reference voltage and the frequency of the oscillator.

15. The method according to claim 13 applied to the switching circuit device further comprising:
- a controlled oscillator, and
- a frequency divider to divide the output of the controlled oscillator by a dividing factor of at least one, **characterised in that** said method comprises the following steps:
- driving the controlled oscillator with the output of the switching circuit device,
- feeding back the output of the frequency divider to the input of the clock generator circuit,
- obtaining a substantially constant and precise frequency at the output of the switching circuit device, said substantially constant and precise frequency being inversely proportional to the product of the value of the reference resistance and the value of the switched capacitor and proportional to the dividing factor.
